# EUROPÄISCHE PATENTSCHRIFT

(11) **EP 0 642 166 B1**
(45) Veröffentlichungstag und Bekanntmachung des Hinweises auf die Patenterteilung: **10.12.1997**
(21) Anmeldenummer: 94113641.8
(22) Anmeldetag: 31.08.1994
(51) Int. Cl.: H01L 25/16, H05K 1/18

(54) **Auf Leiterplatten oberflächenmontierbares Multichip-Modul**
On circuit board mounted multichip module
Module à multichip monté sur la surface d'un circuit imprimé

(30) Priorität: 02.09.1993 DE 4329696
(43) Veröffentlichungstag der Anmeldung: 08.03.1995
(73) Patentinhaber: SIEMENS AKTIENGESELLSCHAFT, 80333 München (DE)
(72) Erfinder: Kalivas, Vassilios, D-82110 Germering (DE); Nitsch, Alois, D-81667 München (DE); Peters, Heinz, D-81369 München (DE)

(56) Entgegenhaltungen:
- EP-A- 0 214 621
- EP-A- 0 402 793
- EP-A- 0 540 247
- WO-A-92/11654
- US-A- 5 045 914
- US-A- 5 222 014
- ELECTRONIC PACKAGING AND PRODUCTION, Bd.28, Nr.6, Juni 1988, MASSACHUSETTS US Seiten 80 - 81 D. B. WHITNEY
- IBM TECHNICAL DISCLOSURE BULLETIN., Bd.35, Nr.7, Dezember 1992, NEW YORK US Seiten 330 - 331
- NEC RESEARCH AND DEVELOPMENT, Bd.33, Nr.1, Januar 1992, TOKYO JP Seiten 32 - 39 K. UMEZAWA ET AL

## Beschreibung

Die Erfindung betrifft ein auf Leiterplatten oberflächenmontierbares Multichip-Modul, mit auf einem Dünnfilm- oder Dickschicht-Substrat fixierten elektronischen Bauelementen und mit SMD-fähigen Anschlußelementen. Module dieser Art befinden sich bereits auf dem Markt.

Das Ziel, den gesamten Schaltungsumfang einer mehrere ICs umfassenden elektronischen Baugruppe in einem einzigen Bauelement zur Verfügung stellen zu können, ohne dabei den aufwendigen Weg hin zu applikationsspezifischen ICs gehen zu müssen, ist derzeit durch ein Multichip-Modul (MCM) erreichbar. Beim MCM werden Dünnfilm- oder Dickschicht-Substrate als Träger von Standardbauelementen, insbesondere von marktüblichen ICs, eingesetzt, die mittels ein- oder mehrlagiger, auf dem Substrat aufgebrachten Schaltungsstrukturen verbunden sind. Derartige MCMs sollten, gehaust oder ungehaust, wie Einzelbauteile weiterverarbeitbar, d. h. in andere Systeme integrierbar sein. Dünnfilm-Substrate werden aus Keramik hohe Güte oder aus Glas hergestellt und weisen vakuumtechnisch abgeschiedene und anschließend fototechnisch strukturierte Widerstands-, Dielektrikums- und Leitbahnschichten auf. Derartige Dünnfilm-Substrate zeichnen sich zwar im Vergleich zu den im Siebdruckverfahren hergestellten Dickschichtschaltungen durch höhere Qualitätsmerkmale (Verdrahtungsdichte, Präzision und Stabilität der in den Dünnfilm-Schaltungsstrukturen integrierten Bauelemente) aus, sind jedoch, abhängig von der Substratflache, relativ kostenaufwendig. Die Kosten eines Dünnfilm-Substrats betragen, bei gleicher Fläche, ein Vielfaches einer entsprechenden Dickfilmschaltung.

Bei den bisherigen, zur Integration in Leiterplatten vorgesehenen Multichip-Modulen werden die Anschlußelemente auf dem Keramik-Substrat angebracht. Um die unterschiedlichen thermischen Ausdehnungen zwischen der Substrat-Keramik und der Leiterplatte auszugleichen, werden hierzu die in der Hybridtechnik allgemein üblichen Anschlußkämme verwendet. Hierdurch wird jedoch die Gesamt fläche des Moduls vergrößert, da die Anschlußkämme über die Substratflache hinausragen. Hinzu kommt, daß die Zahl der möglichen Anschlüsse für viele Anwendungen zu gering ist. Darüber hinaus können die relativ kostenaufwendigen Anschlußkämme leicht beim Handling beschädigt werden.

Aus der internationalen Anmeldung WO 92/11654 ist es bekannt, aus Kostengründen und zur Verbesserung der elektrischen Werte, einen einzelnen Chip auf einer Leiterplatte statt auf einem Keramikplättchen anzubonden. Insbesondere im Hinblick auf ein spezielles Umhäusungsverfahren wird dort ferner vorgeschlagen, die den Chip tragende Leiterplatte nicht wie üblich mittels Steckstiften in entsprechende Aufnahmelöcher einer Hauptleiterplatte einzudrücken, sondern auf der Rückseite der durchkontaktierten Träger-Leiterplatte Reflow-fähige Lotballungen vorzusehen. Der Chip wird dabei vorzugsweise direkt auf der Leiterplatte befestigt, er kann jedoch auch mittels eines Leitklebers fixiert sein. Um das mit zunehmender Größe des Einzelchips auftretende Problem einer unterschiedlichen thermischen Ausdehnung zwischen einem Leiterplatten-Substrat aus Plastik und dem Siliziumchip zu lösen, wird außerdem vorgeschlagen, zwischen dem Leitkleber des Chips und den Leiterbahnen der Träger-Leiterplatte eine die mechanischen Druckkräfte verringernde metallische Versteifungsschicht vorzusehen. Multichip-Module werden in der genannten Anmeldung nicht erwähnt.

Aufgabe der vorliegenden Erfindung ist es, ein verbessertes auf Leiterplatten oberflächenmontierbares Multichip-Modul gemäß Anspruch 1 zu schaffen.

Erfindungsgemäß wird dies dadurch erreicht, daß bei einem Modul der eingangs genannten Art das Keramik-Substrat auf einer ersten Seite einer zum Modul gehörenden, Schaltungsstrukturen aufweisenden Leiterplatte mittels eines flexiblen Klebers befestigt und mittels Bondverbindungen an die Schaltungsstrukturen kontaktiert ist, und daß die Anschlußelemente durch auf der Rückseite der Leiterplatte angebrachte, annähernd kugelförmige Lotballungen gebildet sind, die über Durchkontaktierungen mit den Schaltungsstrukturen auf der ersten Seite der Leiterplatte verbunden sind.

Das erfindungsgemäße Modul ist insbesondere bei Verwendung von Zinn-Lotballungen SMD (Surface-Mounted-Device)-fähig. Vorteilhafterweise wird die Modulgröße durch die Anschlußelemente nicht vergrößert. Da die Lotballungen ohne weiteres ganzflächig aufgebracht werden können, ist zudem eine hohe Anschlußzahl erreichbar. Das Modul kann mit geringem Aufwand umhaust werden und ist damit gegenüber mechanischen Einflüssen unempfindlich und zudem für die automatische Bestückung des Moduls in Hauptleiterplatten geeignet.

Um die Fläche des kostenaufwendigen Keramik-Substrats auf ein Minimum zu reduzieren, ist es vorteilhaft, die Widerstände des Moduls auf die Leiterplatte aufzudrucken und weitere passive Bauelemente ebenfalls nicht auf dem Keramik-Substrat, sondern auf der Leiterplatte anzuordnen. Weitere Ausgestaltungen der Erfindung sind in Unteransprüchen gekennzeichnet.

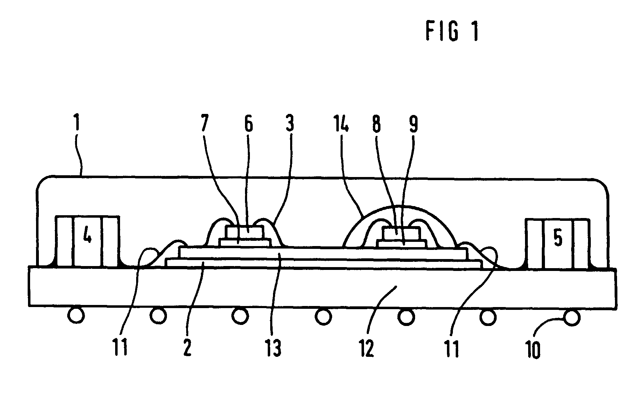

Die Erfindung und weitere Vorteile werden nachfolgend an einem Ausführungsbeispiel anhand der einzigen Figur der Zeichnung, die schematisch und im Schnitt eine Seitenansicht eines erfindungsgemäßen Moduls zeigt, noch näher erläutert.

Das in der Figur dargestellte Modul kann mittels der Lotballungen 10 beispielsweise in einem Reflow-Ofen in eine Hauptleiterplatte eingelötet werden. Das hier beispielsweise unter Verwendung eines Dünnfilm-Substrats 13 aufgebaute Modul weist einschließlich seiner Schutzkappe 1 eine maximale Bauteilhöhe von etwa 5 mm und Seitenabmessungen von bis zu 32 mm x 32 mm auf. In der Figur sind ganzflächig im großen Raster von beispielsweise 2 mm auf der Rückseite der Leiterplatte 12 angebrachte Lotballungen 10 dargestellt. Es resultiert demnach auch bei grobem Raster eine große Anschlußzahl, wodurch sich vorteilhafterweise die sonst üblichen Fine-Pitch-Probleme vermeiden lassen.

Im in der Figur gezeigten Ausführungsbeispiel ist die Dünnfilm-Mehrlagenkeramik 13 ganzflächig mittels einer Schicht flexiblen Isolierklebers 2 auf die Leiterplatte 12 geklebt. Dieser handelsübliche flexible Isolierkleber 2 ist geeignet, die bei Erwärmung entstehenden mechanischen Spannungen, die bei einem Multichip-Modul aufgrund seiner Größe in viel stärkerem Maß als bei einem einzelnen Chip auftreten, auszugleichen. Ein flexibler Leitkleber könnte, abgesehen von der schlechteren Flächenausnutzung, ebenso verwendet werden. Das Dünnfilm-Substrat 13 ist mittels Bondverbindungen 11 mit den in mehreren Lagen, einschließlich aufgedruckter und abgeglichener Widerstände, auf der Leiterplatte 12 vorhandenen Schaltungsstrukturen und Leitbahnen elektrisch verbunden. Außer dem Dünnfilm-Substrat 13 ist auf die Leiterplatte 12 ein passives Bauelement 4 leitend geklebt, wahrend ein weiteres passives Bauelement 5 auf die Leiterplatte 12 gelötet ist. Alle auf der Oberseite der Leiterplatte 12 befindlichen Elemente sind über die Schaltungsstrukturen mit in der Figur nicht dargestellten Durchkontaktierungen verbunden, die die Verbindung zu den Lotballungen 10 auf der Rückseite herstellen.

Es ist vorteilhaft, daß Modul zum Schutz vor mechanischer Beschädigung und um die Hauptleiterplatten mit dem Modul automatisch bestücken zu können, auf dem größten Teil seiner Oberseite durch eine Schutzkappe 1 abzudecken. Diese kann beispielsweise aus Keramik oder Kunststoff bestehen und einfach aufgeklebt sein. Es ist jedoch auch möglich, daß die Schutzkappe durch einen insbesondere mit Weichgelverguß gefüllten, insbesondere gitterförmigen Versteifungsrahmen und durch einen darauf angebrachten Schnappdeckel gebildet ist.

Auf dem Dünnfilm-Substrat 13 können die Bauelemente 6, 8 beispielsweise leitend geklebt 7 oder wärmeleitend, aber isolierend geklebt 9 sein. Auch wenn das Modul insgesamt durch eine Schutzkappe 1 abgedeckt ist, kann es in einigen Fallen wünschenswert sein, auf dem Dünnfilm-Substrat 13 angeordnete Bauelemente 8 einzeln mittels einer Epoxidharzabdeckung 14 oder einer Plastik- oder Metallkappe zu umhäusen. Auf dem Dünnfilm-Substrat 13 sind üblicherweise mindestens einlagige Schaltungsstrukturen aufgebracht, an die die auf dem Dünnfilm-Substrat 13 fixierten Bauelemente 6, 8 mittels Bondverbindungen 3 kontaktiert sind. Eine Minimierung der Substratflache, also eine große Nutzenfaktorerhöhung, ist bei Beschränkung auf ein allein mittels Bonddrahttechnik kontaktiertes Dünnfilm-Substrat 13, auf dem selbst wiederum Bauelemente 6, 8 platzsparend, also wenn möglich ungehaust, durch Bondverbindungen oder in Flipchiptechnik ankontaktiert sind, erreichbar.

## Patentansprüche

1. Auf Leiterplatten oberflächenmontierbares Multichip-Modul mit auf einem Dünnfilm- oder Dickschicht-Substrat fixierten elektronischen Bauelementen und mit SMD-fähigen Anschlußelementen,
**dadurch gekennzeichnet,**daß das Dünnfilm- oder Dickschicht-Substrat ein Keramik-Substrat (13) ist,
daß das Keramik-Substrat (13) auf der Oberseite einer zum Modul gehörenden, Schaltungsstrukturen aufweisenden Leiterplatte (12) mittels eines flexiblen Klebers (2) befestigt und mittels Bondverbindungen (11) an die Schaltungsstrukturen kontaktiert ist, und daß die Anschlußelemente durch auf der Rückseite der Leiterplatte (12) angebrachte, annähernd kugelförmige Lotballungen (10) gebildet sind, die über Durchkontaktierungen mit den Schaltungsstrukturen auf der Oberseite der Leiterplatte (12) verbunden sind.

2. Modul nach Anspruch 1,
**dadurch gekennzeichnet,**
daß die Schaltungsstrukturen mindestens einlagig strukturierte Leitbahn- und Widerstands-Schichten aufweisen, und daß auf ihnen außer dem Keramik-Substrat (13) mindestens ein weiteres diskretes Bauelement (4, 5) fixiert und angeschlossen ist.

3. Modul nach Anspruch 1 oder 2,
**dadurch gekennzeichnet,**
daß das Modul auf im wesentlichen seiner ganzen Oberseite derart durch eine Schutzkappe (1) abgedeckt ist, daß es automatisiert verarbeitbar ist.

4. Modul nach Anspruch 3,
**dadurch gekennzeichnet,**
daß die Schutzkappe (1) durch eine auf die Oberseite des Moduls geklebte Keramik- oder Kunststoffkappe gebildet ist.

5. Modul nach Anspruch 3,
**dadurch gekennzeichnet,**
daß die Schutzkappe (1) durch einen insbesondere mit Weichgelverguß gefüllten, insbesondere gitterförmigen Versteifungsrahmen und durch einen darauf angebrachten Schnappdeckel gebildet ist.

6. Modul nach einem der Ansprüche 1 bis 5,
**dadurch gekennzeichnet,**
daß mindestens eines der auf dem Keramik-Substrat (13) oder auf der Leiterplatte (12) angeordneten Bauelemente (4, 5, 6, 8) einzeln mit einer Epoxidharzabdeckung (14) oder einer Plastik- oder Metallkappe versehen ist.

7. Modul nach einem der Ansprüche 1 bis 6,
**dadurch gekennzeichnet,**
daß die Lotballungen (10) aus Reflow-fähigem Zinn-Lotmaterial bestehen.

8. Modul nach einem der Ansprüche 1 bis 7,
**dadurch gekennzeichnet,**
daß die Lotballungen (10) auf der Rückseite der Leiterplatte (12) ganzflächig im Raster angebracht sind.

9. Modul nach einem der Ansprüche 1 bis 8,
**dadurch gekennzeichnet,**
daß auf dem Keramik-Substrat (13) mindestens einlagige Schaltungsstrukturen aufgebracht sind, an die die auf dem Substrat (13) fixierten Bauelemente (6, 8) mittels Bondverbindungen (3) oder in Flipchiptechnik kontaktiert sind.

## Claims

1. Multichip modules which can be surface-mounted on printed circuit boards, having electronic components fixed on a thin-film or thick-film substrate and having terminal elements with SMD capability, characterized in that the thin-film or thick-film substrate is a ceramic substrate (13), in that the ceramic substrate (13) is fastened by means of a flexible adhesive (2) on the top side of a printed circuit board (12), which belongs to the module and has circuit structures, and makes contact with the circuit structures by means of bonding connections (11), and in that the terminal elements are formed by approximately spherical solder agglomerations (10), which are provided on the rear side of the printed circuit board (12) and are connected to the circuit structures on the top side of the printed circuit board (12) via plated-through holes.

2. Module according to Claim 1, characterized in that the circuit structures have conductive track and resistor layers which are structured in an at least single-layer manner, and in that, in addition to the ceramic substrate (13), at least one further, discrete component (4, 5) is fixed on them and connected.

3. Module according to Claim 1 or 2, characterized in that the module is covered on essentially its entire top side by a protective cap (1) in such a way that it can be processed in an automated manner.

4. Module according to Claim 3, characterized in that the protective cap (1) is formed by a ceramic or plastic cap which is adhesively bonded onto the top side of the module.

5. Module according to Claim 3, characterized in that the protective cap (1) is formed by a reinforcing frame, which, in particular, is in the form of a lattice and is filled, in particular, with soft gel potting, and by a snap-on cover provided on the said frame.

6. Module according to one of Claims 1 to 5, characterized in that at least one of the components (4, 5, 6, 8) arranged on the ceramic substrate (13) or on the printed circuit board (12) is provided individually with an epoxy resin covering (14) or a plastic or metal cap.

7. Module according to one of Claims 1 to 6, characterized in that the solder agglomerations (10) are composed of reflowable tin solder material.

8. Module according to one of Claims 1 to 7, characterized in that the solder agglomerations (10) are provided over the whole area, in a grid pattern, on the rear side of the printed circuit board (12).

9. Module according to one of Claims 1 to 8, characterized in that at least single-layer circuit structures are applied to the ceramic substrate (13), the components (6, 8) fixed on the substrate (13) making contact with the said circuit structures by means of bonding connections (3) or using flip-chip technology.

## Revendications

1. Module multipuce susceptible d'être monté sur la surface d'un circuit imprimé, comprenant des composants électroniques fixés sur un substrat à feuille mince ou à couche épaisse et des éléments de connexion SMD, caractérisé en ce que le substrat à feuille mince ou à couche épaisse est un substrat de céramique (13), en ce que le substrat de céramique (13) est fixé au moyen d'une colle souple (2) sur la face supérieure d'un circuit imprimé (12) faisant partie du module et comportant des structures de circuit et est connecté aux structures de circuit au moyen de liaisons du type bond (11), et en ce que les éléments de connexion sont formés par des accumulations de soudure (10) de forme essentiellement sphérique disposées sur la face arrière du circuit imprimé (12), qui sont raccordées aux structures de circuit placées sur la face supérieure du circuit imprimé (12) par des connexions transversales.

2. Module selon la revendication 1, caractérisé en ce que les structures de circuit comportent des couches conductives et résistives structurées en au moins une couche et en ce que, outre le substrat de céramique (13), au moins un autre composant (4, 5) discret y est fixé et raccordé.

3. Module selon la revendication 1 ou 2, caractérisé en ce que le module est couvert sur essentiellement toute sa face supérieure par une capsule de protection (1) de manière à permettre son traitement automatique.

4. Module selon la revendication 3, caractérisé en ce que la capsule de protection (1) est formée par une capsule de céramique ou de plastique collée sur la face supérieure du module.

5. Module selon la revendication 3, caractérisé en ce que la capsule de protection (1) est formée par un cadre de renfort contenant en particulier une masse de remplissage à base de gel souple et ayant en particulier la forme d'une grille et par un couvercle encliquetable monté sur celui-ci.

6. Module selon l'une des revendications 1 à 5, caractérisé en ce qu'au moins l'un des composants (4, 5, 6, 8) disposés sur le substrat de céramique (13) ou sur le circuit imprimé (12) est pourvu individuellement d'un recouvrement (14) en résine époxy ou d'une capsule plastique ou métallique.

7. Module selon l'une des revendications 1 à 6, caractérisé en ce que les accumulations de soudure (10) sont en étain à braser susceptible d'une réfusion.

8. Module selon l'une des revendications 1 à 7, caractérisé en ce que les accumulations de soudure (10) sont montées sous forme de grille sur la toute la face arrière du circuit imprimé (12).

9. Module selon l'une des revendications 1 à 8, caractérisé en ce que des structures de circuit formant au moins une couche sont déposés sur le substrat de céramique (13), auxquels les composants (6, 8) fixés sur le substrat (13) sont connectés au moyen de liaisons (3) du type bond ou selon la technique flip-chip.
